# EUROPEAN PATENT SPECIFICATION

(11) **EP 2 450 965 B1**
(45) Date of publication and mention of the grant of the patent: **22.10.2014**
(21) Application number: 10794348.2
(22) Date of filing: 30.06.2010
(51) Int. Cl.: H01L 31/042

(54) **PHOTOVOLTAIC POWER-GENERATING APPARATUS**
PHOTOVOLTAISCHE STROMERZEUGUNGSVORRICHTUNG
APPAREIL DE PRODUCTION D'ÉNERGIE PHOTOVOLTAÏQUE

(30) Priority: 30.06.2009 KR 20090058789
(43) Date of publication of application: 09.05.2012
(73) Proprietor: LG Innotek Co., Ltd., Seoul 100-714 (KR)
(72) Inventor: JEE, Suk Jae, Seoul 100-714 (KR)
(74) Representative: Bethenod, Marc
(86) International application number: PCT/KR2010/004227
(87) International publication number: WO 2011/002213

(56) References cited:
- JP-A- 9 186 353
- JP-A- 11 261 096
- US-A1- 2008 134 497
- US-A1- 2008 135 094
- US-A1- 2009 034 204
- US-B1- 6 385 972

## Description

### [Technical Field]

The embodiment relates to a solar cell apparatus.

### [Background Art]

A solar cell module for converting photo energy into electric energy through the photoelectric transformation has been extensively used to obtain clean energy contributing to environmental conservation of the earth.

As the photoelectric transformation efficiency of a solar cell has been improved, a solar cell system including the solar cell module is used for the residential purpose.

The performance of the solar cell may be degraded as heat is applied thereto, so the structure capable of effectivelydissipatingthe heat hasbeen studied and researched. Documents US 6385972 B1 and US 2008/135094 A1 are closely relate prior art documents.

### [Disclosure]

### [Technical Problem]

The embodiment provides a solar cell apparatus capable of effectively dissipating heat and preventing degradation of power generation and having superior durability.

### [Technical Solution]

A solar cell apparatus according to one embodiment includes a solar cell panel; a first heat dissipation member under the solar cell panel; and a plurality of second heat dissipation members inserted into the solar cell panel and the first heat dissipation member.

A solar cell apparatus according to one embodiment includes a substrate; a first heat dissipationmember under the substrate; and a second heat dissipation member inserted into the substrate through the first heat dissipation member.

A solar cell apparatus according to one embodiment includes a lower substrate; a solar cell on the lower substrate; and an upper substrate on the solar cell, wherein a plurality of holes are formed in a bottom surface of the lower substrate.

### [Advantageous Effects]

According to the solar cell apparatus of the embodiment, the heat can be effectively dissipated by first and second heat dissipation members. In particular, the heat generated from the solar cell panel can be effectively transferred to the first heat dissipation member through the second heat dissipation member.

In addition, since the second heat dissipation member is inserted into the solar cell panel, a contact area between the solace cell panel and the heat dissipation members can be increased. Thus, the heat of the solar cell panel can be effectively transferred to the heat dissipation members.

As a result, the solar cell apparatus according to the embodiment can prevent the degradation of the power generation efficiency and the durability caused by the high temperature. In addition, the solar cell apparatus according to the embodiment can effectively dissipate the heat without using an additional device.

Further, the first and second heat dissipation members may include metals having high thermal conductivity. In addition, the first heat dissipation member may further include a cooling pin. Thus, the solar cell apparatus according to the embodiment can be air-cooled. The specific embodiment of the invention is as recited in claim 1. Claims 2-10 recite further advantageous embodiments.

### [Description of Drawings]

FIG. 1 is an exploded perspective view showing a solace cell module according to the embodiment;
FIG. 2 is a sectional view showing a solar cell module according to the embodiment;
FIG. 3 is a plan view showing first and second heat dissipation members;
FIG. 4 is a plan view showing a bottom surface of a lower substrate; and
FIGS. 5 to 9 are views showing the procedure for manufacturing a solar cell module according to the embodiment.

### [Best Mode]

### [Mode for Invention]

In the description of the embodiments, it will be understood that when a panel, a frame, a plate, a part, or a fin is referred to as being "on" or "under" another panel, another frame, another plate, another part, or another fin, it can be "directly" or "indirectly" on the other panel, frame, plate, part, or pin, or one or more intervening elements may also be present. Such a position has been described with reference to the drawings. The thickness and size of each element shown in the drawings may be exaggerated, omitted or schematically drawn for the purpose of convenience or clarity. In addition, the size of elements does not utterly reflect an actual size.

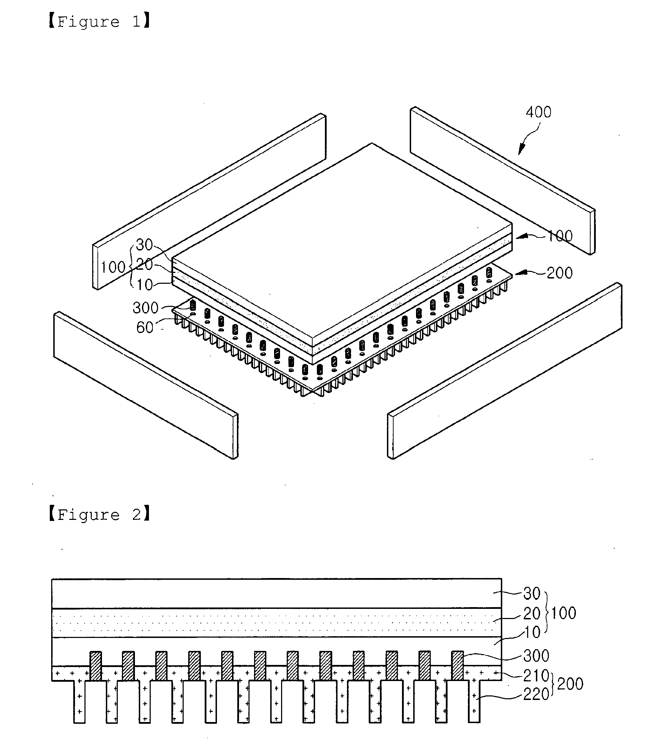

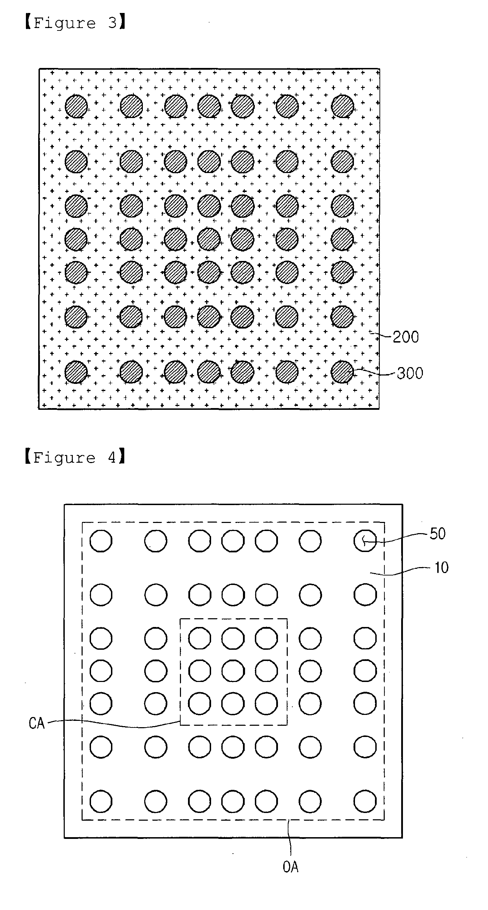

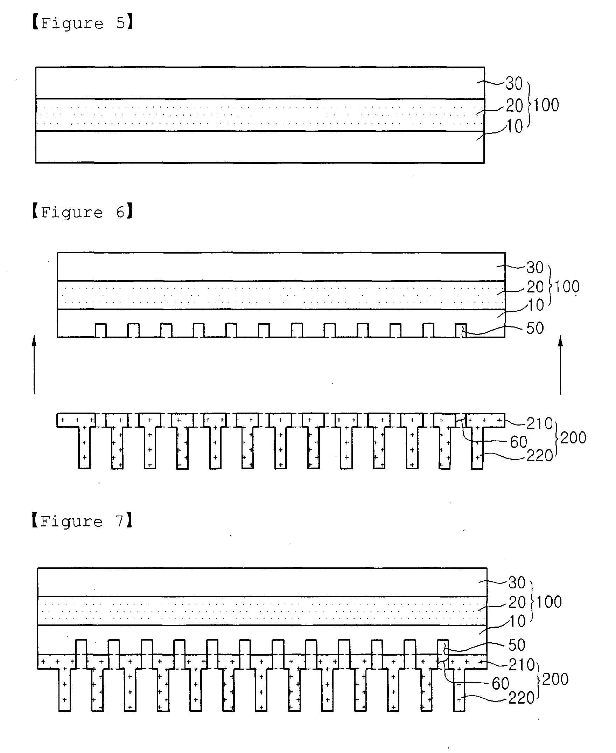

FIG. 1 is an exploded perspective view showing a solace cell module according to the embodiment, FIG. 2 is a sectional view showing a solar cell module according to the embodiment, FIG. 3 is a plan view showing first and second heat dissipationmembers, FIG. 4 is a plan view showing a bottom surface of a lower substrate, and FIGS. 5 to 9 are views showing the procedure for manufacturing a solar cell module according to the embodiment.

Referring to FIGS. 1 to 9, the solar cell module according to the present invention includes a solar cell panel 100, a first heat dissipation member 200, a plurality of second heat dissipation members 300 and a frame 400.

The solar cell panel 100 receives solar light to convert the solar light into electric energy. The solar cell panel 100 includes a lower substrate 10, a solar cell 20 and an upper substrate 30. In addition, the solar cell panel 100 may further include a damping film covering the solar cell 20.

The lower substrate 10 has a plate shape. The lower substrate 10 supports the solar cell 20 and the upper substrate 30. The lower substrate 10 may include an insulating material. The lower substrate 10 may be a glass substrate, a plastic substrate or a metal substrate. The support substrate may include a soda lime substrate. The support substrate may be transparent. The support substrate may be rigid or flexible.

A plurality insertion holes 50 are formed on the bottom surface of the lower substrate 10. The insertion holes 50 may have shapes corresponding to the second heat dissipation members 300. A depth of the insertion hole 50 may be about 1/3 to 2/3 based on a thickness of the lower substrate 10.

The insertion holes 50 can be formed through a laser processing or a drill processing. The size and the number of the insertion holes 50 may vary depending on the size of the solar cell panel 100 and the shapes of the second heat dissipation members 300.

The density of the insertion holes located at the center of the lower substrate 10 is higher than the density of the insertion holes located at the outer peripheral portion of the lower substrate 10. The lower substrate 10 may be divided into a central area CA located at the center of the lower substrate 10 and an outer peripheral area OA surrounding the central area CA. In the same way, the solar cell panel 100 can be divided into a central area CA and an outer peripheral area OA.

An interval between the insertion holes located at the central area CA is smaller than an interval between the insertion holes located at the outer peripheral area OA. In detail, the insertion holes located at the central area CA are densely arranged as compared with the insertion holes located at the outer peripheral area OA. In more detail, the interval between the insertion holes 50 may be increased from the central area CA to the outer peripheral area OA.

The insertion hole 50 may have a diameter in the range of about 2mm to about 15mm. The insertion hole 50 may have a cylindrical configuration.

The solar cell 20 is disposed on the lower substrate 10. The solar cell 20 receives solar light to convert the solar light into electric energy. For instance, the solar cell 20 may include a CIGS-based solar cell, a silicon-based solar cell or a fuel-sensitive solar cell.

The upper substrate 30 is disposed on the solar cell 20. The upper substrate 30 is transparent and serves as a light receiving surface to which the solar light is incident. The upper substrate 30 is protective glass for protecting the solar cell 20. For instance, the upper substrate 30 may include tempered glass.

The first heat dissipationmember 200 is disposed below the solar cell panel 100. The first heat dissipation member 200 dissipates the heat generated from the solar cell panel 100. The first heat dissipation member 200 may have high thermal conductivity. For instance, the first heat dissipation member 200 may include Cu, Al or an alloy thereof.

The first heat dissipation member 200 includes a plurality of perforation holes 60 corresponding to the insertion holes 50. The perforation holes 60 are formed through the first heat dissipation member 200. In addition, the perforation holes 60 have shapes the same as those of the corresponding insertion holes 50 when viewed from the top.

The first heat dissipation member 200 includes a heat dissipation plate 210 and a plurality of heat dissipation fins 220.

The heat dissipation plate 210 has a plate shape. The heat dissipation plate 210 has a thickness in the range of about 1mm to about 3mm. The heat dissipation plate 210 is opposite to the lower substrate and has a shape the same as that of the lower substrate 10 when viewed from the top. In addition, the heat dissipation plate 210 directly makes contact with the solar cell panel 100. In detail, the heat dissipation plate 210 is bonded to the bottom surface of the solar cell panel 100, that is, to the underside of the lower substrate 10 through the thermal pressing process.

The heat dissipation fins 220 extend downward from the heat dissipation plate 210. The heat dissipation plate 210 can be integrally formed with the heat dissipation fins 220, but the embodiment is not limited thereto. For instance, the heat dissipation plate 210 can be coupled with the lower substrate 10 through various methods depending on the reaction temperature of the curing agent.

The second heat dissipation members 300 are partially inserted into the insertion holes 50 while passing through the perforation holes 60. The second heat dissipation members 300 may have column shapes. For instance, the second heat dissipation members 300 may have cylindrical column shapes or polygonal column shapes. Each second heat dissipation member 300 may have a diameter in the range of about 2mm to about 15mm and the tolerance between the second heat dissipation member 300 and the insertion hole 50 may be in the range of about -0.1mm to about -1mm.

The second heat dissipation members 300 directly make contact with the solar cell panel 100, that is, the lower substrate 10. In addition, the second heat dissipation members 300 directly make contact with the first heat dissipation member 200.

The second heat dissipation members 300 have high thermal conductivity. For instance, the second heat dissipation members 300 have the thermal conductivity in the range of about 340W/m.K to about 400W/m.K. The second heat dissipation members 300 may include Cu, Al or an alloy thereof.

Inaddition, the secondheatdissipationmembers 300 may have the thermal expansion coefficient corresponding to the thermal expansion coefficient of the lower substrate 10. In detail, since the thermal expansion coefficient of the second heat dissipation members 300 is substantially equal to the thermal expansion coefficient of the lower substrate 10, the lower substrate 10 may not be damaged by the expansion of the second heat dissipation members 300.

The first and second heat dissipation members 200 and 300 may have the same materials. In detail, the first and second heat dissipation members 200 and 300 may have the same metals. In addition, the first and second heat dissipation members 200 and 300 may be integrally formed with each other.

The number of the second heat dissipation members 300 disposed in the central area CA may be larger than the number of the second heat dissipation members 300 disposed in the outer peripheral area OA. In detail, the second heat dissipation members 300 are densely arranged in the central area CA. Thus, the interval between the second heat dissipation members 300 disposed in the central area CA is shorter than the interval between the second heat dissipation members 300 disposed in the outer peripheral area OA. In more detail, the interval between the second heat dissipation members 300 may become increased from the central area CA to the outer peripheral area OA of the solar cell panel 100.

In particular, when the solar cell module according to the embodiment generates power by receiving the solar cell, the central area CA of the solar cell panel 100 may be heated more than the outer peripheral area OA of the solar cell panel 100. At this time, since a larger number of second heat dissipation members 300 are disposed on the central area CA, the heat can be uniformly dissipated from the solar cell panel 100.

The frame 400 receives the solar cell panel 100, the first heat dissipation member 200 and the second heat dissipation members 300. The frame 400 surrounds lateral sides of the solar cell panel 100 and the first heat dissipation member 200.

In order to effectively dissipate the heat, the frame 400 is only disposed at the lateral sides of the solar cell panel 100 and the first heat dissipation member 200. In addition, a width of the frame 400 may be larger than the sum of the thicknesses of the solar cell panel 100 and the first heat dissipation member 200.

The heat generated from the solar cell panel 100 is dissipated to the outside through the first and second heat dissipation members 200 and 300. In detail, the heat generated from the solar cell panel 100 is dissipated to the outside through the second heat dissipation members 300, the heat dissipation plate 210 and the heat dissipation fins 220.

In this case, the sum of the contact area between the solar cell panel 100 and the first heat dissipation member 200 and the contact area between the solar cell panel 100 and the second heat dissipation members 300 can be improved.

Therefore, the heat generated from the solar cell panel 100 can be effectively transferred to the first and second heat dissipation members 200 and 300.

In addition, the second heat dissipation members 300 are inserted into the insertion holes 50 formed in the lower substrate 10 to couple the first heat dissipation member 200 with the solar cell panel 100. Thus, the solar cell module according to the embodiment can be assembled with reinforced coupling force. As a result, the strength of the solar cell module can be improved.

Therefore, the solar cell module according to the embodiment can be effectively cooled by the first and second heat dissipation members 200 and 300 without using an additional cooling device.

In particular, the solar cell panel 100 can be sufficiently cooled through the air-cooling scheme by using the heat dissipation plate 210 and the heat dissipation fins 220.

Thus, the solar cell module according to the embodiment can prevent the degradation of the performance caused by the high temperature so that the durability of the solar cell module can be improved. That is, the solar cell panel may have the improve performance and durability.

In order to manufacture the solar cell module according to the embodiment, the solar cell panel 100 is prepared.

Referring to FIG. 5, the solar cell 20 is formed on the lower substrate 10, the damping film is formed on the solar cell 20 and the upper substrate 30 is formed on the damping film. After that, the upper substrate 30 is press-bonded onto the solar cell 20 through the damping film, thereby forming the solar cell panel 100.

Referring to FIG. 6, the insertion holes 50 are formed in the bottom surface of the lower substrate 10 through the laser process or the drilling process. In contrast, the insertion holes 50 can be primarily formed before the solar cell 20 and the upper substrate 30 have been formed.

Referring to FIG. 7, the first heat dissipation member 200 is coupled with the bottom surface of the lower substrate 10. At this time, the first heat dissipation member 200 is aligned with the solar cell panel 100 such that the perforation holes 60 can be positioned corresponding to the insertion holes 50.

According to the present embodiment, the lower substrate 10 is coupled with the first heat dissipation member 200 after separately forming the insertion holes 50 and the perforation holes 60 in the lower substrate 10 and the first heat dissipation member 200, respectively. However, the embodiment is not limited thereto. For instance, the insertion holes 50 and the perforation holes 60 can be simultaneously formed after the lower substrate 10 has been coupled with the first heat dissipation member 200.

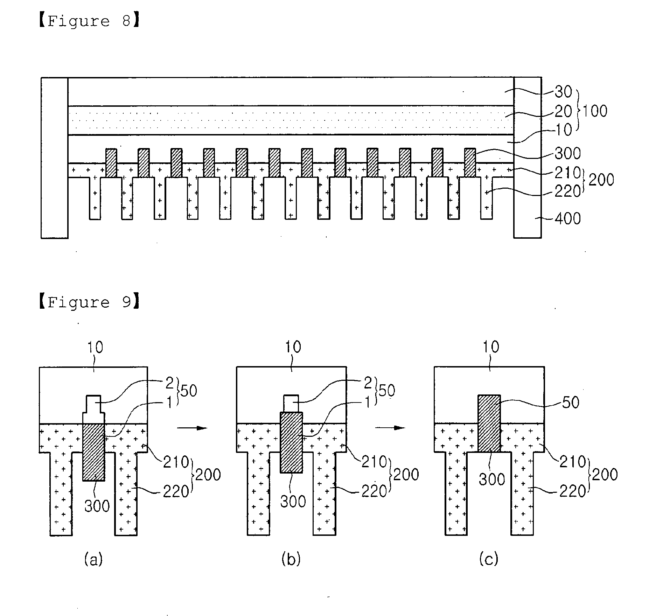

In addition, as shown in FIG. 8, the second heat dissipation members 300 are inserted into the insertion holes 50 through the perforation holes 60. Further, as shown in FIG. 9, the insertion holes 50, into which the second heat dissipation members 300 are inserted, may have the step difference.

In detail, the insertion holes 50 may include first insertion holes 1 and second insertion holes 2 having the step difference with respect to the first insertion holes 1. In this case, the second heat dissipation members 300 are primarily inserted into the first insertion holes 1 through the perforation holes 60 and then inserted into the second insertion holes 2 by applying pressure to the second heat dissipation members 300.

Thus, the coupling force between the second heat dissipation members 300 and the lower substrate 10 can be reinforced. At this time, the second heat dissipation members 300 are inserted into the insertion holes 50 and partially inserted into the perforation holes 60.

That is, the second heat dissipation members 300 inserted into the perforation holes 60 can be partially connected to the first heat dissipation member 200. In addition, the second heat dissipation members 300 can be integrally formed with the first heat dissipation member 200 through the welding process or the like.

Thus, the heat generated from the solar cell panel 100 can be dissipated to the outside through the second and first heat dissipation members 300 and 200. At this time, the contact area between the lower substrate 10 and the second heat dissipation members 300 can be adjusted by controlling the depth of the insertion holes 50.

Therefore, according to the solar cell module of the embodiment, the contact area between the lower substrate 10 and the second heat dissipation members 300 can be maximized while maintaining the strength of the lower substrate 10.

Then, as shown in FIG. 2, the frame 400 is disposed to surround the lateral sides of the solar cell panel 100 and the first heat dissipation member 200, thereby forming the solar cell module according to the embodiment.

The frame 400 may be longer than the heat dissipation fins 220 of the first heat dissipation member 200. In addition, the frame 400 can be configured to surround only the lateral sides of the solar cell panel 100 and the first heat dissipation member 200. In this case, the solar cell module according to the embodiment can easily receive wind from the outside.

As described above, the solar cell module according to the embodiment can effectively dissipate the heat by using the first and second dissipation members 200 and 300.

In particular, the heat generated from the solar cell panel 100 can be effectively transferred to the first heat dissipation member 200 through the second heat dissipation members 300 inserted into the solar cell panel 100.

As a result, the solar cell module according to the embodiment can prevent the degradation of the power generation caused by the high temperature and can improve the durability. In addition, the solar cell module according to the embodiment can effectively dissipate the heat without using additional power.

Further, since the first and second heat dissipation members 200 and 300 have the superior thermal conductivity, the cooling performance can be improved. In particular, the solar cell module can be cooled without the wind. If the wind blows to the solar cell module, the solar cell module can be air-cooled, so that the cooling performance can be improved.

In addition, the solar cell panel 100 can be solely applied to the solar cell module. That is, the solar cell panel 100 can effectively dissipate the heat without the first and second heat dissipation members 200 and 300. This is because the surface area of the bottom surface of the lower substrate 10 can be increased due to the insertion holes 50.

### [Industrial Applicability]

The solar cell apparatus according to the embodiment can be used in the field of the solar cell.

## Claims

1. A solar cell apparatus comprising:
a solar cell panel (100) comprising a central area and an outer peripheral area surrounding the central area;
a first heat dissipation member (200) under the solar cell panel; and
a plurality of second heat dissipation members (300) inserted into the solar cell panel and the first heat dissipation member and dissipating heat generated from the solar cell panel together with the first heat dissipation member, and
**characterised in that** the interval between the second heat dissipation members located in the central area is shorter than the interval between the second heat dissipation members located in the outer peripheral area.

2. The solar cell apparatus of claim 1, wherein the solar cell panel comprises:
a substrate;
a back electrode layer on the substrate;
a light absorbing layer on the back electrode layer; and
a front electrode layer on the light absorbing layer,
wherein a plurality of insertion holes are formed in the substrate.

3. The solar cell apparatus of claim 2, wherein the first heat dissipation member is formed with a plurality of perforation holes corresponding to the insertion holes.

4. The solar cell apparatus of claim 3, wherein the second heat dissipation members are inserted into the insertion holes and the perforation holes.

5. The solar cell apparatus of claim 2, wherein the insertion holes have a depth corresponding to about 1/3 to about 2/3 based on a thickness of the substrate.

6. The solar cell apparatus of claim 1, wherein the first heat dissipation member comprises:
a heat dissipation plate facing the solar cell panel; and
a plurality of heat dissipation fins extending from the heat dissipation plate.

7. The solar cell apparatus of claim 2, wherein the second heat dissipation members have a thermal expansion coefficient corresponding to a thermal expansion coefficient of the substrate.

8. The solar cell apparatus of claim 1, wherein the second heat dissipation members have thermal conductivity in a range of about 340W/m.K to about 400W/m.K.

9. The solar cell apparatus of claim 1, further comprising a frame for receiving the solar cell panel and the first heat dissipation member, wherein the frame has a width larger than a sum of thicknesses of the solar cell panel and the first heat dissipation member.

10. The solar cell apparatus of claim 1, wherein the second heat dissipation members include Cu, Al or an alloy thereof.

## Patentansprüche

1. Solarzellengerät, das Folgendes aufweist :
eine Solarzellentafel (100), die einen zentralen Bereich und einen äußeren Umfangsbereich, der den zentralen Bereich umgibt, aufweist,
ein erstes Wärmeableitelement (200) unterhalb der Solarzellentafel, und
eine Mehrzahl zweiter Wärmeableitelemente (300), die in die Solarzellentafel und das erste Wärmeableitelement eingefügt sind und Wärme ableiten, die von der Solarzellentafel gemeinsam mit dem ersten Wärmeableitelement erzeugt wird, und
**dadurch gekennzeichnet, dass** der Abstand zwischen den zweiten Wärmeableitelementen, die sich in dem zentralen Bereich befinden, kürzer ist als der Abstand zwischen den zweiten Wärmeableitelementen, die sich in dem äußeren Umfangsbereich befinden.

2. Solarzellengerät nach Anspruch 1, wobei die Solarzellentafel Folgendes aufweist:
eine Unterlage,
eine Rückelektrodenschicht auf dieser Unterlage,
eine Licht absorbierende Schicht auf der Rückelektrodenschicht, und
eine Frontelektrodenschicht auf der Licht absorbierenden Schicht,
wobei eine Mehrzahl von Einsetzbohrungen in der Unterlage ausgebildet ist.

3. Solarzellengerät nach Anspruch 2, wobei das erste Wärmeableitelement mit einer Mehrzahl von Perforierungsbohrungen, die den Einsetzbohrungen entsprechen, ausgebildet ist.

4. Solarzellengerät nach Anspruch 3, wobei die zweiten Wärmeableitelemente in die Einsetzbohrungen und die Perforierungsbohrungen eingesetzt sind.

5. Solarzellengerät nach Anspruch 2, wobei die Einsetzbohrungen eine Tiefe aufweisen, die etwa 1/3 bis 2/3 basierend auf einer Stärke des Substrats entsprechen.

6. Solarzellengerät nach Anspruch 1, wobei das erste Wärmeableitelement Folgendes aufweist:
eine Wärmeableitplatte gegenüber der Solarzellentafel und
eine Mehrzahl von Wärmeableitrippen, die sich von der Wärmeableitplatte erstreckt.

7. Solarzellengerät nach Anspruch 2, wobei die zweiten Wärmeableitelemente einen Wärmedehnungskoeffizienten aufweisen, der einem Wärmedehnungskoeffizienten der Unterlage entspricht.

8. Solarzellengerät nach Anspruch 1, wobei die zweiten Wärmeableitelemente eine Wärmeleitfähigkeit in einem Bereich von etwa 340 W/m.K bis etwa 400 W/m.K aufweisen.

9. Solarzellengerät nach Anspruch 1, das ferner einen Rahmen zum Aufnehmen der Solarzellentafel und des ersten Wärmeableitelements aufweist, wobei der Rahmen eine Breite hat, die größer ist als eine Summe von Stärken der Solarzellentafel und des ersten Wärmeableitelements.

10. Solarzellengerät nach Anspruch 1, wobei die zweiten Wärmeableitelemente Cu, Al oder eine Legierung daraus aufweisen.

## Revendications

1. Dispositif de cellule solaire comprenant :
un panneau de cellule solaire (100) comprenant une zone centrale et une zone périphérique extérieure entourant la zone centrale ;
un premier élément de dissipation de chaleur (200) sous le panneau de cellule solaire ; et
une pluralité de deuxièmes éléments de dissipation de chaleur (300) insérés dans le panneau de cellule solaire et le premier élément de dissipation de chaleur et dissipant la chaleur générée à partir du panneau de cellule solaire conjointement au premier élément de dissipation de chaleur, et
**caractérisé en ce que** l'intervalle entre les deuxièmes éléments de dissipation de chaleur situés dans la zone centrale est plus court que l'intervalle entre les deuxièmes éléments de dissipation de chaleur situés dans la zone périphérique extérieure.

2. Dispositif de cellule solaire selon la revendication 1, dans lequel le panneau de cellule solaire comprend :
un substrat ;
une couche d'électrode arrière sur le substrat ;
une couche d'absorption de lumière sur la couche d'électrode arrière ; et
une couche d'électrode avant sur la couche d'absorption de lumière,
dans lequel une pluralité de trous d'insertion est formée dans le substrat.

3. Dispositif de cellule solaire selon la revendication 2, dans lequel le premier élément de dissipation de chaleur est formé avec une pluralité de trous de perforation correspondant aux trous d'insertion.

4. Dispositif de cellule solaire selon la revendication 3, dans lequel les deuxièmes éléments de dissipation de chaleur sont insérés dans les trous d'insertion et les trous de perforation.

5. Dispositif de cellule solaire selon la revendication 2, dans lequel les trous d'insertion ont une profondeur correspondant à environ 1/3 à environ 2/3 sur la base d'une épaisseur du substrat.

6. Dispositif de cellule solaire selon la revendication 1, dans lequel le premier élément de dissipation de chaleur comprend :
une plaque de dissipation de chaleur faisant face au panneau de cellule solaire ; et
une pluralité d'ailettes de dissipation de chaleur s'étendant à partir de la plaque de dissipation de chaleur.

7. Dispositif de cellule solaire selon la revendication 2, dans lequel les deuxièmes éléments de dissipation de chaleur ont un coefficient de dilatation thermique correspondant à un coefficient de dilatation thermique du substrat.

8. Dispositif de cellule solaire selon la revendication 1, dans lequel les deuxièmes éléments de dissipation de chaleur ont une conductivité thermique dans une plage d'environ 340 W/m.K à environ 400 W/m.K.

9. Dispositif de cellule solaire selon la revendication 1, comprenant en outre un châssis pour recevoir le panneau de cellule solaire et le premier élément de dissipation de chaleur, dans lequel le châssis a une largeur supérieure à une somme d'épaisseurs du panneau de cellule solaire et du premier élément de dissipation de chaleur.

10. Dispositif de cellule solaire selon la revendication 1, dans lequel les deuxièmes éléments de dissipation de chaleur comprennent Cu, Al ou un alliage de ceux-ci.
